(19) Europäisches Patentamt
European Patent Office
Office européen des brevets

(11) **EP 1 887 446 A1**

(12) **EUROPÄISCHE PATENTANMELDUNG**

(43) Veröffentlichungstag:
**13.02.2008 Patentblatt 2008/07**

(51) Int Cl.:
*G05B 19/418* (2006.01)  *H03M 13/11* (2006.01)
*G06F 11/10* (2006.01)

(21) Anmeldenummer: **06118346.3**

(22) Anmeldetag: **02.08.2006**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(71) Anmelder: **Siemens Aktiengesellschaft**
**80333 Munich (DE)**

(72) Erfinder: **Hammer, Jörg**
**6331 Hünenberg (CH)**

(54) **Verfahren zur seriellen asynchronen Übertragung von Daten in einer Anordnung zur Überwachung, Steuerung und Regelung einer betriebstechnischen Anlage eines Gebäudes**

(57) In einem Verfahren zur seriellen, asynchronen und zeichenweisen Datenübertragung eines mehrere Datenworte $z(0)$ bis $Z(3)$ aufweisenden Datenstroms wird ein zusätzlichen Paritäts-Datenworts D generiert und übertragen. Das Paritäts-Datenwort D wird derart generiert, dass in einem aus den Datenworten $Z(0)$ bis $Z(3))$ und dem zusätzlichen Paritäts-Datenwort D gebildeten Datenblock eine vorbestimmte Parität hergestellt wird, wobei zur Berechnung der Parität jeweils bei im Datenstrom benachbarten Datenworten verschiedene Bitpositionen und damit unterschiedliche Wertigkeiten ausgewählt werden. Ausserdem wird für das das Paritäts-Datenwort und jedes Datenwort $Z(0)$ bis $Z(3)$ die Querparität generiert und übertragen. Durch das Verfahren kann die Wahrscheinlichkeit wesentlich erhöht werden, dass Übertragungsfehler unterschiedlichen Ursprungs in einem Empfänger detektiert werden.

FIG 4

**Beschreibung**

Die Erfindung bezieht sich auf ein Verfahren sowie auf eine Anordnung zur Durchführung des Verfahrens gemäss den Oberbegriffen der Ansprüche 1 und 7.

Solche Verfahren eignen sich beispielhaft zur sicheren Übertragung von Daten zwischen einem Sender und einem Empfänger über ein gemeinsames Übertragungsmedium, wobei beispielsweise der Sender ein Ein-/Ausgabemodul für Feldgeräte und der Empfänger ein Schnittstellenmodul ist, durch welches das genannte Übertragungsmedium mit einem weiteren Kommunikationssystem verbunden ist.

Derartige Verfahren sind mit Vorteil insbesondere in Anordnungen zur Überwachung, Steuerung und/oder Regelung von Prozessgrössen in komplexen technischen Systemen einsetzbar, wobei beispielhaft Heizungs-, Lüftungs- und Klimaanlagen, Zutritts- und Feuerüberwachungssysteme oder allgemein Gebäudeautomationsanlagen - die auch als Gebäudeleitsysteme bezeichnet werden - genannt seien, in welchen insbesondere auch Raumklimagrössen beeinflusst werden. In einer Gebäudeautomationsanlage sind in der Regel eine Vielzahl so genannter Feldgeräte wie Sensoren und Stellglieder zu bedienen. Für den Datenaustausch zwischen einzelnen Anlagenteilen der Gebäudeautomationsanlage werden vorwiegend Bussysteme benutzt, wobei in einer Anlage durchaus mehrere verschiedenartige Bussysteme eingesetzt werden, die in der Regel hierarchisch miteinander verbunden sind.

Eine Anordnung zur Überwachung, Steuerung und Regelung einer betriebstechnischen Anlage eines Gebäudes ist beispielsweise aus EP 1 211 582 A1 bekannt. Die Anordnung weist mehrere Ein-/Ausgabemodule zur Bedienung von Feldgeräten und ein Bussystem auf, durch welches die Ein-/Ausgabemodule miteinander verbunden sind. Das dazu vorgeschlagene Bussystem basiert beispielsweise auf serieller asynchroner Datenkommunikation über einen Zweidraht-Datenbus.

Aus EP 1 345 122 A1 ist eine Vorrichtung zur Anbindung eines synchronen 16-Bit-Datenbusses an einen synchronen 64-Bit-Datenbus bekannt. Die Taktfrequenz des 16-Bit Datenbusses ist dabei etwa viermal höher als die Taktfrequenz des 64-Bit-Datenbusses. In der Vorrichtung wird ein so genanntes DIP-4 (diagonal interleaved parity) Codierungsverfahren zur Fehlererkennung benutzt.

Bei einer seriellen asynchronen Datenkommunikation wird in der Regel eine sogenannte NRZ (non return to zero) Codierung eingesetzt. Dabei wird die Übertragung eines Zeichens mit einem Startbit eingeleitet. Am Ende des zu übertragenen Zeichens wird ein Stoppbit angefügt. Zusätzlich kann vor dem Stoppbit ein so genanntes Paritäts-Bit eingefügt werden, durch welches für das übertragene Zeichen eine gerade oder eine ungerade Parität hergestellt wird. In der Regel synchronisiert der Empfänger auf die negative Flanke des Startbits und tatstet die nachfolgenden Bits mit seinem Empfängertakt ab. Durch die festgelegte Parität sind gewisse Übertragungsfehler vom Empfänger erkennbar.

Wird nun eine Meldung, welche aus mehreren Zeichen besteht, übertragen, wird häufig ein zusätzliches Sicherheitsfeld übermittelt, um die Richtigkeit der gesamten Meldung überprüfen zu können. Für die Berechnung des Sicherheitsfeldes sind verschiedene Verfahren bekannt, wie zum Beispiel arithmetische Summenbildung, zyklische Redundanzprüfung CRC (cyclic redundancy check) oder die Generierung von Spalten- oder Längsparität.

Bei einer derartigen seriellen asynchronen Übertragung kann es nun zu Fehlern kommen, wenn der Zeitpunkt der Abtastung beim Empfänger soweit verschoben ist, dass kein stabiler Signalzustand mehr erkannt wird. Bei einer zeitlich verschobenen Abtastung wird fälschlicherweise der Übergang zwischen zwei benachbarten Bits, oder im Extremfall sogar das benachbarte Bit abgetastet. Der Ursprung für ein solches Fehlverhalten liegt beispielsweise in Abweichungen der Taktfrequenzen bei Sender und Empfänger, in einer Ungenauigkeit bei der Startbit-Synchronisation oder auch in Signalverzerrungen. Abweichungen der Taktfrequenzen können beispielsweise durch Bauteiltoleranzen oder durch Temperaturunterschiede zwischen dem Sender und dem Empfänger verursacht werden.

Eine gewisse Differenz zwischen den Taktfrequenzen des Senders und des mit diesem verbundenen Empfängers führt in der Regel also dazu, dass die Wahrscheinlichkeit einer fehlerhaften Abtastung umso grösser wird, je weiter weg sich der Abtastpunkt von der Startbit-Synchronisation befindet. Im Fall, dass die beiden zuletzt übertragenen Bit falsch eingelesen werden, wird dies durch die Quer-Parität nicht erkannt. Geschieht dies nun bei einer geraden Anzahl von Zeichen, ist dies auch mittels Längs-Parität nicht zu erkennen.

Insbesondere in einer Anlage mit erhöhten Sicherheitsanforderungen, wie in einem Gebäudeautomationssystem, bei dem durch fehlerhafte Informationsübertragung hohe Schäden oder Gefahren für Bewohner entstehen können, sind sicherheitsrelevante Datenströme entsprechend zuverlässig zu übertragen.

Der Erfindung liegt die Aufgabe zugrunde, ein Verfahren zur seriellen asynchronen Übertragung von Daten anzugeben, durch welches eine fehlerhafte Abtastung mit hoher Wahrscheinlichkeit erkennbar ist und welches insbesondere in einer Anordnung zur Überwachung, Steuerung und Regelung einer betriebstechnischen Anlage eines Gebäudes anwendbar und kostengünstig implementierbar ist. Ferner ist eine Anordnung anzugeben, mit der das Verfahren durchführbar ist.

Die genannte Aufgabe wird erfindungsgemäss durch die Merkmale der Ansprüche 1 und 7 gelöst. Vorteilhafte Ausgestaltungen ergeben sich aus den abhängigen Ansprüchen.

Nachfolgend werden Ausführungsbeispiele der Erfindung anhand der Zeichnung näher erläutert.

Es zeigen:

Fig. 1 eine erfindungsgemässe Datenverbindung in einer Anordnung zur Überwachung, Steuerung und Regelung einer betriebstechnischen Anlage eines Gebäudes,

Fig. 2 erfindungsgemäss gesicherte Informationseinheiten zur Übertragung über die Datenverbindung,

Fig. 2a eine vereinfachte Darstellung von Fig. 2 mit der Datensicherung für je zwei Bits der Informationseinheiten,

Fig. 3 eine Variante eines erfindungsgemässen Verfahrens zum Sichern von Informationseinheiten,

Fig. 4 eine weitere Darstellung von erfindungsgemäss gesicherten Informationseinheiten,

Fig. 5 eine Anordnung zur Durchführung eines Verfahrens gemäss der Erfindung,

Fig. 6 eine Darstellung zu einer vorteilhaften Implementierung des Verfahrens, und

Fig. 7 eine weitere Variante eines erfindungsgemässen Verfahrens zum Sichern von Informationseinheiten.

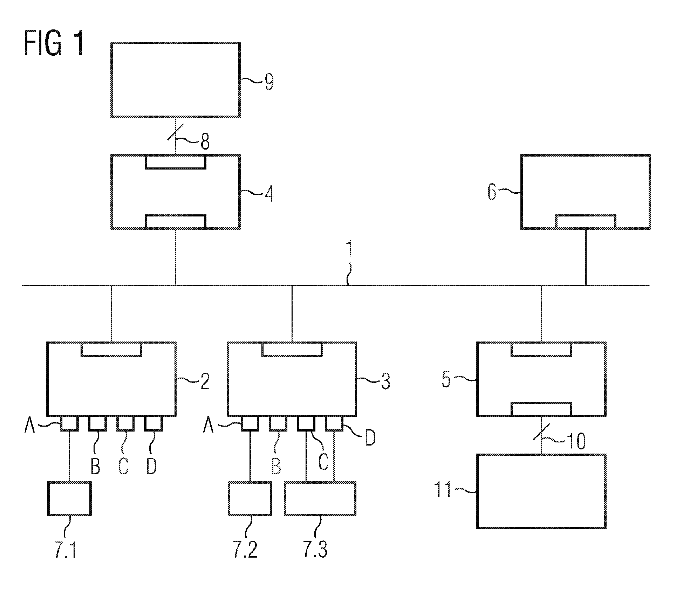

In der Fig. 1 bedeutet 1 ein Übertragungsmedium zur Verbindung von Einheiten 2, 3, 4, 5 und 6 einer Anordnung zur Überwachung, Steuerung und/oder Regelung einer betriebstechnischen Anlage eines Gebäudes.

Beispielhaft sind eine erste Einheit 2 und eine zweite Einheit 3 je ein Ein-/Ausgabemodul zur Bedienung von Feldgeräten 7. Ein Feldgerät 7 ist typischerweise ein Sensor zur Erfassung einer Prozessgrösse oder ein Stellantrieb zur Beeinflussung einer Prozessgrösse.

Selbstverständlich ist die Anzahl der über das Übertragungsmedium 1 miteinander verbundenen Ein-/Ausgabemodule 2 und 3 nicht wie in Fig. 1 dargestellt auf lediglich zwei beschränkt.

Mit Vorteil weist das Ein-/Ausgabemodul 2 oder 3 jeweils mehrere Anschlussstellen A, B, C und D für Feldgeräte 7 auf. Grundsätzlich ist die Anzahl der implementierten Anschlussstellen pro Ein-/Ausgabemodul 2 oder 3 in weiten Grenzen wählbar und auf zulässige Modulkosten, Platzbedarf und auf den zu erwartenden Datenstrom pro Zeiteinheit abgestimmt. Für Gebäudeautomationsanlagen werden beispielsweise acht oder sechzehn Anschlussstellen pro Ein-/Ausgabemodul 2 oder 3 verwirklicht.

Die Anschlussstellen A, B, C und D sind mit Vorteil identisch aufgebaut und beispielsweise universal als Eingabeport und als Ausgabeport einsetzbar, also bidirektional und zwar für analoge Signale und digitale Signale. Die Anschlussstelle A, B, C oder D weist beispielsweise je drei Anschlusspunkte für das Feldgerät 7 auf. Die universelle Anschlussstelle A, B, C oder D ist also für eine Vielzahl von Feldgerättypen einsetzbar und zwar für Sensoren oder Aktuatoren, also für Feldgeräte mit Analog-Eingabe, Analog-Ausgabe, Digital-Eingabe oder Digital-Ausgabe, jeweils mit oder ohne Speisung über die Anschlussstelle A, B, C oder D.

Typische Feldgeräte 7 in Gebäudeautomationsanlagen sind beispielsweise Temperaturfühler, Feuchtefühler, Gas-Sensoren, Türkontakte, Rauchsensoren, Ventil- und Luftklappenantriebe, Sprinklerventile, Lichtschalter und Jalousie-Antriebe.

Je nach Feldgerätetyp ist das Feldgerät 7 also zweiadrig oder mehradrig mit der Anschlussstelle A, B, C oder D verbunden. Bei Bedarf ist das Feldgerät 7 mit mehreren Anschlussstellen verbunden, nämlich beispielsweise dann, wenn das Feldgerät 7 ein Stellglied mit Positionsrückmeldung ist, wobei dann das Stellsignal mit Vorteil an einer ersten Anschlussstelle A ausgegeben und an einer zweiten Anschlussstelle B gleichzeitig ein Zustand oder die aktuelle Position des Stellglieds eingelesen wird.

Beispielsweise ist eine Anschlussstelle A des Ein/Ausgabemoduls 2 mit einem Temperaturfühler 7.1 verbunden, während ein Gassensor 7.2 mit einer Anschlussstelle A und ein Stellglied 7.3 mit Anschlussstellen C und D des Ein/Ausgabemoduls 3 verbunden sind.

Eine dritte mit dem Übertragungsmedium 1 verbundene Einheit 4 ist mit Vorteil ein Regel- und/oder Steuergerät oder ein über ein weiteres Kommunikationssystem 8 mit einem übergeordneten Regel- und/oder Steuergerät 9 verbundenes Schnittstellenmodul, durch welches das Übertragungsmedium 1 und das weitere Kommunikationssystem 8 für einen Datenaustausch physikalisch und logisch aneinander angepasst werden, wobei durch das Schnittstellenmodul in der Regel verschiedenartige Signalträger und verschiedenartige Datenübertragungsprotokolle aufeinander abgestimmt werden.

In einer Variante der Anordnung ist die dritte Einheit 4 über das weitere Kommunikationssystem 8 mit einer übergeordneten Zentrale oder Leitstelle verbunden.

Eine vierte Einheit 5 ist bei Bedarf ein weiteres Schnittstellenmodul, welches über ein zusätzliches Kommunikationssystem 10 mit einem weiteren Gerät 11 verbunden ist. Die Kommunikationssysteme 8 und 10 sind grundsätzlich durch die Kommunikationsfähigkeiten des Regel- und/oder Steuergeräts 9 beziehungsweise des weiteren Geräts 11 gegeben und beispielsweise durch Bussysteme und Technologien wie LON oder LonWorks®, dem Europäische Installationsbus EIB, dem nach deutscher Norm DIN 19245 definierte PROFIBUS, BACnet oder KONNEX implementiert. Grundsätzlich kann das Kommunikationssystem 8 oder 10 auch durch optische Datenkommunikationskanäle oder ein Funknetz verwirklicht sein, beispielsweise durch ein Glasfasernetz oder ein zellulares Telefonnetz, wie etwa GSM oder UMTS.

Eine fünfte Einheit 6 ist ein Servicemodul, welches bei Bedarf an das Übertragungsmedium 1 anschliessbar ist. Das Servicemodul 6 dient beispielsweise zur Konfigurierung von Teilfunktionen des Gebäudeautomationssystems, der Inbetriebnahme oder Überwachung von am Übertragungsmedium 1 angeschlossenen Einheiten 2 und 3, oder der Lokalisation von Störungen.

Die Datenkommunikation über das Übertragungsmedium 1 erfolgt grundsätzlich drahtgebunden oder drahtlos. Das Übertragungsmedium 1, an dem die fünf Einheiten 2, 3, 4, 5 und 6 angeschlossen sind, ist bei drahtgebundener Kommunikation beispielhaft ein Zweidrahtbus oder eine zweiadrige Leitung.

In einer Variante sind auch Mittel zur Speisung der Einheiten 2, 3, 4, 5 und 6, und/oder Mittel zur Speisung der angeschlossenen Feldgeräte 7 verfügbar, wobei die elektrische Speisung bei Bedarf mit zusätzlichen elektrischen Leitungen zusammen mit dem Übertragungsmedium 1 vorteilhafterweise in einem gemeinsamen Bussystem verteilt wird.

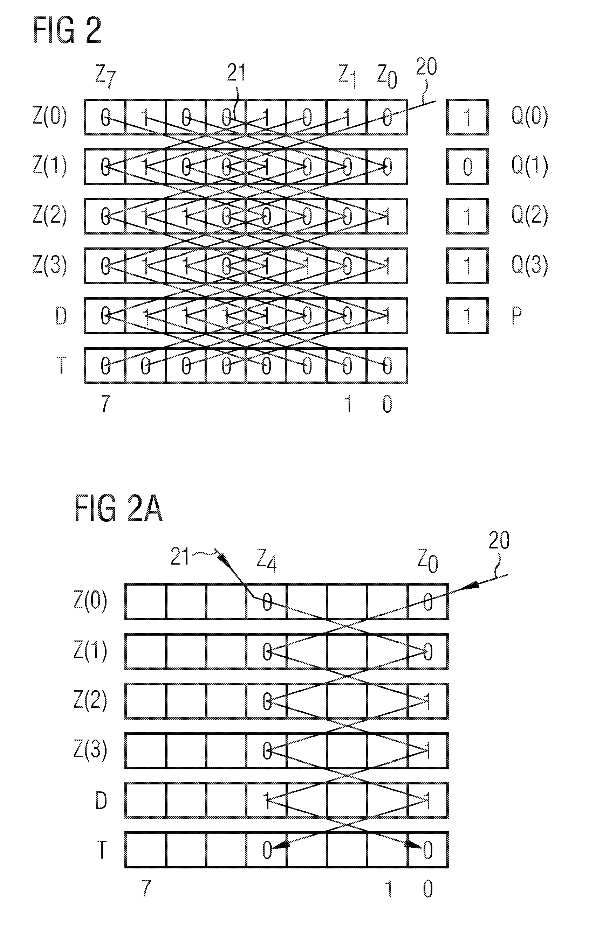

In einem ersten Beispiel weist ein über das Übertragungsmedium 1 zu übertragender Datenstrom vier Informationseinheiten $Z(0)$, $Z(1)$, $Z(2)$ und $Z(3)$ auf (Fig. 2). Die Informationseinheiten $Z(0)$, $Z(1)$, $Z(2)$ und $Z(3)$ haben hier eine Wortlänge von je 8 Bit. Die einzelnen Bits einer Informationseinheit sind hier von der niedrigsten Wertigkeit $Z0$ bis zur höchsten Wertigkeit $Z7$ bezeichnet.

Vor der Übertragung werden die Informationseinheiten $Z(0)$, $Z(1)$, $Z(2)$ und $Z(3)$ erfindungsgemäss durch folgende zwei Verfahrensschritte gesichert:

Schritt 1: Generieren eines entsprechenden Querparitätsbits $Q(0)$, $Q(1)$, $Q(2)$ beziehungsweise $Q(3)$ für jede Informationseinheit $Z(0)$, $Z(1)$, $Z(2)$ und $Z(3)$. Durch das Querparitätsbit wird hier zur zugehörigen Informationseinheit beispielhaft eine gerade Parität hergestellt, das heisst, die Anzahl der auf logisch eins gesetzten Bits in der Informationseinheit und im zugeordneten Querparitätsbit ist gerade.

Schritt 2: Generieren eines zusätzlichen Paritäts-Datenworts D aus den vier Informationseinheiten $Z(0)$, $Z(1)$, $Z(2)$ und $Z(3)$ derart, dass in einem aus den vier je eine Wortlänge acht aufweisenden Informationseinheiten und dem zusätzlichen Paritäts-Datenwort D gebildeten Datenblock eine vorbestimmte Parität hergestellt wird, wobei zur Berechnung der Parität jeweils bei im Datenstrom benachbarten Informationseinheiten bzw. Datenworten verschiedene Bitpositionen und damit unterschiedliche Wertigkeiten ausgewählt werden. Das zusätzliche Paritäts-Datenwort D hat hier beispielhaft die gleiche Wortlänge wie die Informationseinheiten $Z(0)$, $Z(1)$, $Z(2)$ und $Z(3)$, nämlich acht.

In der Fig. 2 ist eine vorteilhafte Variante des Schrittes 2 dargestellt, in der zur Berechnung der Parität bei im Datenstrom benachbarten Datenworten jeweils um vier Bitpositionen auseinander liegende Bits verwendet werden. Die vorteilhafte Distanz der berücksichtigten Bitpositionen ergibt sich aus der halben Wortlänge der Informationseinheiten $Z(0)$, $Z(1)$, $Z(2)$ und $Z(3)$. Zu Gunsten einer übersichtlicheren Darstellung sind in der Fig. 2a von den in der Fig. 2 dargestellten insgesamt acht Verknüpfungswegen zwei Verknüpfungswege 20 und 21 noch einmal separat eingezeichnet. Ein zickzackförmiger Verknüpfungsweg 20 veranschaulicht die Berechnung für das niederwertigste Bit des Paritäts-Datenwortes D. Das niederwertigste bzw. erste Bit $Z0$ der ersten Informationseinheit $Z(0)$, das vierthöchste bzw. fünfte Bit $Z4$ der zweiten Informationseinheit $Z(1)$, das niederwertigste Bit $Z0$ der dritten Informationseinheit $Z(2)$ und das fünfte Bit $Z4$ der vierten Informationseinheit $Z(3)$ bestimmen das niederwertigste Bit des Paritäts-Datenwortes D. Im dargestellten Beispiel wird mit dem Paritäts-Datenwort D eine gerade Parität hergestellt, das heisst also, dass die Anzahl der logischen Werte "1" der berücksichtigten Bits - inklusive dem entsprechenden Bit des Paritäts-Datenworts D - gerade ist. Es versteht sich von selbst, dass in einer alternativen Variante der Datensicherung des Datenblocks eine ungerade Parität generiert werden könnte.

Ein weiterer zickzackförmiger Verknüpfungsweg 21 veranschaulicht die Berechnung für das vierthöchste oder auch fünfte Bit des Paritäts-Datenwortes D. Das fünfte Bit $Z4$ der ersten Informationseinheit $Z(0)$, das niederwertigste Bit $Z0$ der zweiten Informationseinheit $Z(1)$, das fünfte Bit $Z4$ der dritten Informationseinheit $Z(2)$ und das niederwertigste Bit $Z0$ der vierten Informationseinheit $Z(3)$ bestimmen das vierthöchste oder auch fünfte Bit des Paritäts-Datenwortes D.

Ausserdem wird auch zum Paritäts-Datenwort D ein Paritätsbit P generiert, durch welches vorteilhafterweise die gleiche Paritätsart wie bei den Informationseinheiten $Z(0)$, $Z(1)$, $Z(2)$ und $Z(3)$ hergestellt wird.

Wenn die Parität über einen aus den Informationseinheiten $Z(0)$, $Z(1)$, $Z(2)$ und $Z(3)$ und dem Paritäts-Datenwort D gebildeten Datenblock nach dem in den Fig. 2 und Fig. 2a dargestellten Bildungsgesetz hergestellt wird, ergeben sich für ein zusätzliches Datenwort T an allen Bitpositionen je eine binäre Null. Durch diese Tatsache kann in einem Empfänger eine fehlerhafte Parität im übertragenen Datenblock vereinfacht festgestellt werden.

Es hat sich gezeigt, dass die in der in Fig. 2 dargestellte Ausführung der Datensicherung des Datenblocks, in der zu benachbarten Informationseinheiten gehörende Bits, die zur Bildung eines Paritätsbits verwendet werden, jeweils eine halbe Wortlänge der Informationseinheiten $Z(0)$, $Z(1)$, $Z(2)$ und $Z(3)$ auseinander liegen, einerseits die Fehlererkennung deutlich steigern und andrerseits mit wenig Aufwand mittels Mikroprozessor implementierbar sind. Der Befehlssatz eines Mikroprozessors umfasst in der Regel einen Befehl, durch den die beiden Hälften eines Registers oder eines beliebigen adressierten Datenworts vertauscht werden, wodurch die angesprochene Variante der Erfindung besonders einfach programmierbar ist und ausserdem Programmcode mit relativ kurzen Laufzeiten ermöglicht.

Zur Generierung eines vorteilhaften Paritäts-Datenwortes D für eine Folge mit einer Anzahl k Informationseinheiten Z(i) ist folgende Grundformel G1 einsetzbar:

$$D_a = \left( \sum_{i=0}^{k-1} Z(i)_{(i+a+k) \bmod n} \right) \bmod 2 \quad \forall\, a \in \{0 .. m-1\}$$

In dieser Grundformel G1 bedeuten:

m    die Wortlänge des Paritätsdatenwortes D
n    die Wortlänge der Informationseinheiten Z(i)
k    die Anzahl Informationseinheiten
$D_a$    das berechnetes Bit an der Stelle a im Paritätsdatenwort D
i    die Position der Informationseinheit in der Folge beginnend mit Z(0) bis Z (k-1)

$Z(i)_j$ das Bit and der Stelle j einer Informationseinheit Z(i) mod die mathematische Modulo-Funktion, also der Rest der ganzzahligen Division

Je nach gefordertem Abstand der zur Generierung der Parität berücksichtigten Bits von zwei benachbarten Informationseinheiten und deren Abstandsrichtung - positiv oder negativ bzw. links oder rechts versetzt - ist die Grundformel G1 mit geringem Aufwand den Anforderungen anpassbar.

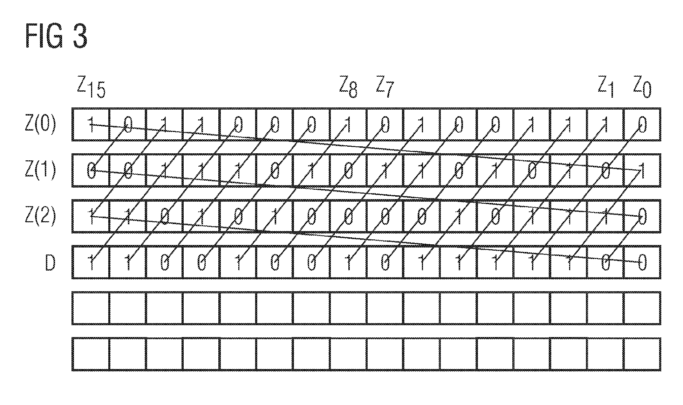

Fig. 3 zeigt eine Variante zur Bildung eines Paritäts-Datenwortes D, wobei in diesem Beispiel Informationseinheiten Z(0), Z(1) und Z(2) wie auch das Paritäts-Datenwort D jeweils 15 Bit aufweisen. Zur Berechnung der Parität bei im Datenstrom benachbarten Informationseinheiten werden jeweils um eine Bitposition auseinander liegende Bits verknüpft. Diese einfache Variante hat den Vorteil, dass für eine Implementierung mittels kostengünstigen Mikroprozessor neben wortweisen Exklusiv-Oder-Befehlen hauptsächlich wenige Maschinenzyklen beanspruchende Ein-Bit-Schiebe- oder Ein-Bit-Rotationsbefehle eingesetzt werden können, was insgesamt besonders kurze Programmlaufzeiten ermöglicht.

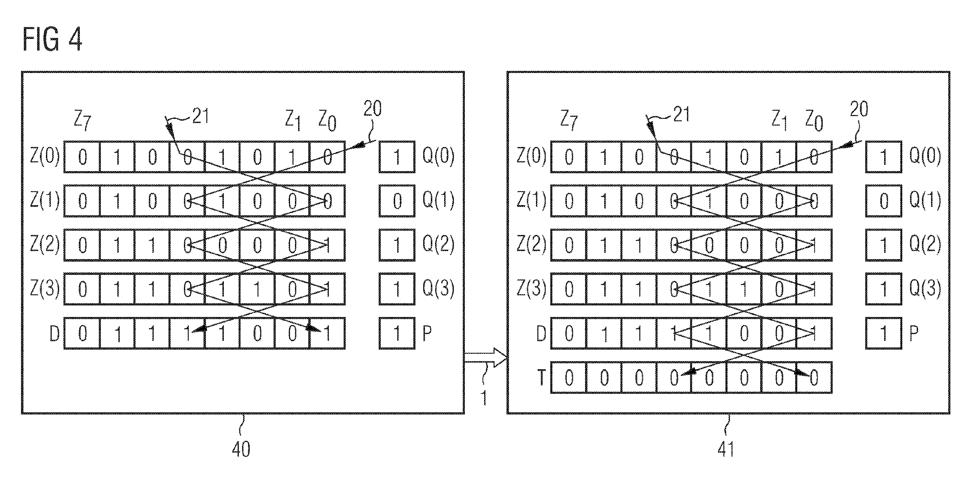

In der Fig. 4 sind die durch das Paritäts-Datenwort D und die Querparitätsbits Q(0), Q(1), Q(2), Q(3) und P erfindungsgemäss gesicherten Informationseinheiten Z(0), Z(1), Z(2) und Z(3) in einem Sendemodul 40 aufbereitet. Ein die Informationseinheiten Z(0), Z(1), Z(2) und Z(3) und das Paritäts-Datenwort D aufweisender Datenblock wird zeichenweise inklusive dem zugehörigen Querparitätsbit über das Übertragungsmedium 1 an ein Empfangsmodul 41 übertragen. Im Empfangsmodul 41 wird der übertragene Datenblock analysiert. Ein Übertragungsfehler äussert sich mit hoher Wahrscheinlichkeit dadurch, dass entweder wenigstens eine der im Empfangsmodul ermittelten Querparitäten mit den übermittelten Paritätsbit Q(0), Q(1), Q(2), Q(3) oder P nicht übereinstimmt, oder der Wert des im Empfangsmodul 41 berechneten zusätzlichen Datenworts T nicht mit dem erwarteten Wert übereinstimmt. Abhängig ob mit dem Paritätsdatenwort D gerade oder ungerade Parität hergestellt wird, sind bei fehlerfreier Übertragung alle Bits des zusätzlichen Datenworts auf Null oder dann auf Eins gesetzt.

Jeder der am Übertragungsmedium 1 angeschlossenen Einheiten 2, 3, 4, 5 und 6 verfügt über ein Exemplar des Sendemoduls 40 und ein Exemplar des Empfangsmoduls 41, wobei das Sendemodul 40 und das Empfangsmodul 41 vorteilhafterweise jeweils als Sender-Empfänger-Modul implementiert wird.

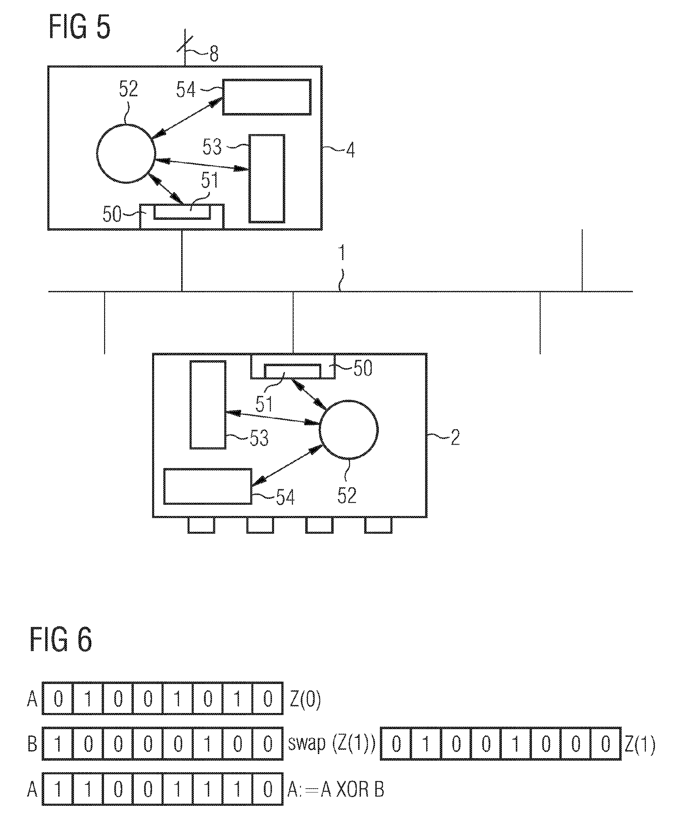

In der Fig. 5 sind die beiden am Übertragungsmedium 1 angeschlossenen Einheiten 2 und 4 etwas detaillierter dargestellt.

Die Einheit 2 und die Einheit 4 weisen je eine Schnittstelleneinrichtung 50 auf, welche vorteilhafterweise über einen Ein-/Ausgabe-Pufferspeicher 51 verfügt. Die Schnittstelleneinrichtung 50 ermöglicht eine bidirektionale Datenkommunikation zwischen den beiden Einheiten 2 und 4 über das Übertragungsmedium 1. Eine vorteilhafte Implementierung der Einheit 2 wie auch der Einheit 4 weist ausserdem wenigstens einen Mikroprozessor 52, ein Programm 53 und einen zusätzlichen Speicherbereich 54 für den die Informationseinheiten Z(0), Z(1), Z(2) und Z(3) und das Paritätsdatenwort D enthaltenden Datenstrom. Das auf den Mikroprozessor 52 abgestimmte Programm 53 ist mit Vorteil so ausgelegt, dass die beiden Einheiten 2 und 4 für die über das Übertragungsmedium 1 ablaufende Datenkommunikation sowohl als Sender als auch als Empfänger funktionsfähig sind.

In der beispielsweise als Sender eingesetzten Einheit 2 wird der Mikroprozessor 52 durch das Programm 53 derart gesteuert, dass ein zusätzlichen Paritäts-Datenworts D aus den vier Informationseinheiten Z(0), Z(1), Z(2) und Z(3) derart generiert wird, dass in einem aus den vier je eine gewisse Wortlänge aufweisenden Informationseinheiten Z(0), Z(1), Z(2) und Z(3) und dem zusätzlichen Paritäts-Datenwort D gebildeten Datenblock eine vorbestimmte Parität hergestellt wird, wobei zur Berechnung der Parität jeweils bei im zu sendenden Datenstrom benachbarten Informationseinheiten bzw. Datenworten verschiedene Bitpositionen und damit unterschiedliche Wertigkeiten ausgewählt werden.

In der beispielsweise als Empfänger eingesetzten Einheit 4 wird der Mikroprozessor 52 durch das Programm 53 derart gesteuert, dass im empfangenen Datenstrom die Parität über einen aus den Informationseinheiten Z(0), Z(1), Z(2) und Z(3) und dem Paritäts-Datenwort D gebildeten Datenblock und einem zusätzlichen Datenwort T hergestellt wird. Der Wert des zusätzlichen Datenworts T wird im Programm 53 zur Detektierung von Übertragungsfehlern herangezogen.

Es versteht sich von selbst, dass bei Bedarf, anstelle des Mikroprozessors 52 und des Programms 53 grundsätzlich auch eine entsprechend ausgelegte elektronische Schaltung eingesetzt werden könnte.

Wie schon im Zusammenhang mit der Fig. 2 bzw. Fig. 2a erwähnt, umfasst der Befehlssatz eines Mikroprozessors in der Regel einen Befehl, durch den die beiden Hälften eines Registers oder eines beliebigen, adressierbaren Datenworts vertauscht werden. Der besagte - in gewissen Befehlssätzen auch als SWAP bezeichnete - Befehl zum Vertauschen der beiden Hälften eines Datenworts vertauscht also beispielsweise in einem Acht-Bit-Datenwort das niederwertigste Bit mit dem vierthöchstwertigen, das zweite Bit mit dem dritthöchstwertigen und so weiter.

Fig. 6 zeigt das Prinzip einer vorteilhaften Implementierung der erfindungsgemässen Generierung des Paritätsdatenworts D. Dazu ist ein Auszug des Programms 53 skizziert. Die erste Informationseinheit Z(0) ist in einem Register A des Mikroprozessors 52 abgespeichert, während die zweite Informationseinheit Z(1) im Speicherbereich 54 für den Mikroprozessor 52 verfügbar ist. In einer mit swap (Z(1)) symbolisierte Operation des Mikroprozessor 52 wird der Inhalt der zweiten Informationseinheit Z(1) in ein Register B des Mikroprozessors 52 überführt, wobei dabei die niederwertige Hälfte und die höherwertige Hälfte der zweiten Informationseinheit Z(1) vertauscht werden. Darauf werden in einer mit A := A XOR B symbolisierten Operation des Mikroprozessors 52 die Inhalte der beiden Register A und B derart miteinander verglichen, dass in Register A das Resultat einer so genannten Exklusiv-Oder-Verknüpfung der beiden Register A und B abgespeichert wird. Nachher, in der Fig. 6 nicht mehr dargestellt, wird der Inhalt des Registers A mit der dritten Informationseinheit Exklusiv-Oder verknüpft und das Resultat wiederum in Register A abgelegt. Schliesslich wird der Inhalt des Registers A noch mit der hälftig vertauschten dritten Informationseinheit Z(3) Exklusiv-Oder verknüpft und das Resultat im Register A abgelegt, womit das Paritätsdatenwort D im Register A verfügbar ist. Bei längeren Datenströmen werden einzelne Programmschritte des gezeigten Programmausschnitts entsprechend wiederholt, wobei also grundsätzlich jede zweite Informationseinheit vor der Exklusiv-Oder-Verknüpfung hälftig zu vertauschen ist.

In weiteren vorteilhaften Varianten der Erfindung werden zur Berechnung der Parität jeweils bei im Datenstrom benachbarten Datenworten verschiedene Bitpositionen und damit unterschiedliche Wertigkeiten derart ausgewählt, dass einerseits die Wertigkeiten benachbarter Datenworte unterschiedlich weit auseinander liegen und ein Zyklus zwischen zwei Operationen, bei denen sich eine identische Paarbildung bei der Auswahl der für die Operationen berücksichtigen Bitpositionen ergibt, möglichst lang ist. Eine hohe Sicherheit bei derartigen Varianten ist erreichbar, wenn der Zyklus zwischen zwei Operationen, bei denen sich eine identische Paarbildung bei der Auswahl der für die Operationen berücksichtigen Bitpositionen ergibt, gleich der Anzahl k der Informationseinheiten Z(i) des Datenstroms ist.

Mit Vorteil wird für derartige Varianten die Abfolge der berücksichtigten Wertigkeiten bzw. Bitpositionen in einem ersten Vektor $K^{\{0..n-1\}}$ und ein von der Bitposition abhängiger Versatz abhängig von der Bit-Position im Paritätsdatenwort D in einem zweiten Vektor $L^{\{0..m-1\}}$ festgehalten. Zur Berechnung der Parität für derartige Varianten wird die oben dargestellte Grundformel G1 durch einen ersten Vektor $K^{\{0..n-1\}}$ und einen zweiten Vektor $L^{\{0..m-1\}}$ in eine allgemeinere Formel G2 überführt:

$$D_a = \left( \sum_{i=0}^{k-1} Z(i)_{K((L(a)+i+k) \bmod n)} \right) \bmod 2 \quad \forall\, a \in \{0..m-1\}$$

Auch in dieser allgemeineren Formel G2 bedeuten:

m     die Wortlänge des Paritätsdatenwortes D
n     die Wortlänge der Informationseinheiten Z(i)
k     die Anzahl Informationseinheiten
$D_a$     das berechnetes Bit an der Stelle a im Paritätsdatenwort D
i     die Position der Informationseinheit in der Folge beginnend mit Z(0) bis Z(k-1)

$Z(i)_j$ das Bit and der Stelle j einer Informationseinheit Z(i) mod die mathematische Modulo-Funktion, also der Rest der ganzzahligen Division

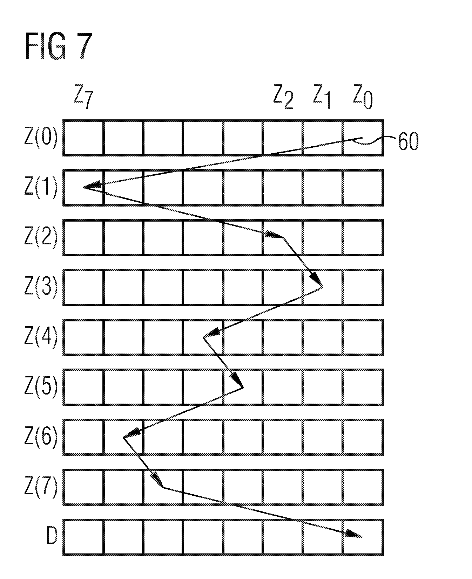

In der Fig. 7 zeigt ein Linienzug 60 den Ablaufweg der bei der Berechnung des niederwertigsten Bits des Paritätsdatenworts D durchgeführten Verknüpfungen. Beispielhaft ist der vorteilhafte Ablaufweg nach der allgemeineren Formel G2 durch den ersten Vektor K = [ 0 7 2 1 4 3 6 5 ] und den zweiten Vektor L = [ 0 3 2 5 4 7 6 1 ] bestimmt.

Bezugszeichenliste

| 1 | Übertragungsmedium |
|---|---|
| 2 | Einheit, erste, Ein-/Ausgabemodul |
| 3 | Einheit, zweite, Ein-/Ausgabemodul |
| 4 | Einheit, dritte, Regel-/oder Steuergerät bzw. Schnittstellenmodul |
| 5 | Einheit, vierte, Schnittstellenmodul, weiteres |
| 6 | Einheit, fünfte, Servicemodul |
| 7 | Feldgerät |
| 7.1 | Temperaturfühler |
| 7.2 | Gassensor |
| 7.3 | Stellglied |
| 8 | Kommunikationssystem |
| 9 | Regel- und/oder Steuergerät, übergeordnetes |
| 10 | Kommunikationssystem, zusätzliches |
| 11 | Gerät, weiteres |

| 20 | Verknüpfungsweg |
|---|---|
| 21 | Verknüpfungsweg, weiterer |

| 40 | Sendemodul |
|---|---|

| 41 | Empfangsmodul |
|---|---|

| 50 | Schnittstelleneinrichtung |
|---|---|
| 51 | Ein-/Ausgabe-Pufferspeicher |
| 52 | Mikroprozessor |
| 53 | Programm |
| 54 | Speicherbereich |
| 60 | Linienzug |

| z(0), .. Z(3) | Informationseinheit |
|---|---|

| Z1..Z7 | einzelnes Bit in Informationseinheit |
|---|---|

| Q(0) .. Q(3) | Querparitätsbit einer entsprechenden Informationseinheit |
|---|---|

| D | Paritäts-Datenwort zum von Z(0) bis Z(3) gebildeten Datenblock |
|---|---|

| T | zusätzliches Datenwort |
|---|---|

**Patentansprüche**

1. Verfahren zur seriellen, asynchronen Datenübertragung eines Datenstroms von einem Sendemodul (2) zu einem Empfangsmodul (4), wobei der Datenstrom mehrere Datenworte (Z(0), Z(1), Z(2), Z(3)) einer konstanten Wortlänge n aufweist und zeichenweise übertragen wird, **gekennzeichnet durch** die Verfahrensschritte:

- Generieren eines zusätzlichen Paritäts-Datenworts D mit einer Wortlänge m aus einer vorbestimmten Anzahl k Datenworte (Z(0), Z(1), Z(2), Z(3)) des Datenstroms im Sendemodul (2) derart, dass in einem aus den k Datenworten (Z(0), Z(1), Z(2), Z(3)) der Länge n und dem zusätzlichen Paritäts-Datenwort D der Länge m gebildeten Datenblock eine vorbestimmte Parität hergestellt wird, wobei zur Berechnung der Parität jeweils bei im Datenstrom benachbarten Datenworten verschiedene Bitpositionen und damit unterschiedliche Wertigkeiten ausgewählt werden;

- Generieren einer Querparität (Q(0); Q(1); Q(2); Q(3)) für ein aus dem Datenstrom gewonnenes Datenwort (Z(0); Z(1); Z(2); Z(3)); und

- Senden der k Datenworte (Z(0), Z(1), Z(2), Z(3)) und des Paritäts-Datenwortes D zeichenweise, wobei zu jedem Datenwort (Z(0); Z(1); Z(2); Z(3)) und zum Paritäts-Datenwort D ein zugehöriges Querparitätsbit (Q(0); Q(1); Q(2); Q(3); P) gesendet wird.

2. Verfahren nach Anspruch 1, **dadurch gekennzeichnet,**
   **dass** zur Berechnung der Parität jeweils bei im Datenstrom benachbarten Datenworten, die niederwertige Hälfte des zeitlich früher auszusendenden Datenwortes mit der höherwertigen Hälfte des zeitlich später auszusendenden Datenwortes bitweise verknüpft wird.

3. Verfahren nach Anspruch 1, **dadurch gekennzeichnet,**
   **dass** zur Berechnung der Parität jeweils bei im Datenstrom benachbarten Datenworten, die höherwertige Hälfte des zeitlich früher auszusendenden Datenwortes mit der niederwertigen Hälfte des zeitlich später auszusendenden Datenwortes bitweise verknüpft wird.

4. Verfahren nach Anspruch 1, **dadurch gekennzeichnet, dass** die Wortlänge m des Paritäts-Datenworts gleich der Wortlänge n der Datenworte des Datenstroms ist.

5. Verfahren nach Anspruch 1, **dadurch gekennzeichnet,**
   **dass**, mit einer Laufvariablen i von 0 bis n-1 und einer ganzzahligen Konstante a aus einem Wertebereich von 1 bis n-1, zur Generierung des Paritäts-Datenworts jeweils bei im Datenstrom benachbarten Datenworten $D_k$ und $D_{k+1}$ das Bit $D_{k(i \bmod n)}$ und das Bit $D_{(k+1)\,((i+a) \bmod n)}$ berücksichtigt wird.

6. Verfahren nach Anspruch 1, **dadurch gekennzeichnet, dass** zur Berechnung der Parität jeweils bei im Datenstrom benachbarten Datenworten verschiedene Bitpositionen und damit unterschiedliche Wertigkeiten derart ausgewählt werden, dass die Wertigkeiten benachbarter Datenworte unterschiedlich weit auseinanderliegen und ein Zyklus zwischen zwei Operationen, bei denen sich eine identische Paarbildung bei der Auswahl der für die Operationen berücksichtigen Bitpositionen ergibt, gleich der Anzahl k Datenworte des Datenstroms ist.

7. Anordnung zur Überwachung, Steuerung und Regelung einer betriebstechnischen Anlage eines Gebäudes, mit einem Sende-(2) und einem Empfangsmodul (4) und einer mit dem Sende- (2) und dem Empfangsmodul (4) verbundenen Datenleitung (1) zur Durchführung eines Verfahrens nach einem der Ansprüche 1 bis 5, **dadurch gekennzeichnet,**
   **dass** das Sendemodul (2) Mittel aufweist,

   - zum Generieren eines zusätzlichen Paritäts-Datenworts mit einer Wortlänge m aus einer vorbestimmten Anzahl k Datenworte des Datenstroms im Sendemodul derart, dass in einem aus den k Datenworten der Länge n und dem zusätzlichen Paritäts-Datenwort der Länge m gebildeten Datenblock eine vorbestimmte Parität hergestellt wird, wobei zur Berechnung der Parität jeweils bei im Datenstrom benachbarten Datenworten verschiedene Bitpositionen und damit unterschiedliche Wertigkeiten ausgewählt werden;
   - zum Generieren einer Querparität Q für ein aus dem Datenstrom gewonnenes Datenwort; und
   - zum Senden der k Datenworte und des Paritäts-Datenwortes zeichenweise, wobei zu jedem Datenwort und zum Paritäts-Datenwort ein zugehöriges Querparitätsbit gesendet wird.

8. Anordnung nach Anspruch 7, **dadurch gekennzeichnet,**
   **dass** das Empfangsmodul (4) Mittel aufweist,

   - zum Generieren eines zusätzlichen Paritäts-Datenworts mit einer Wortlänge m aus einer vorbestimmten Anzahl k Datenworte des Datenstroms im Empfangsmodul derart, dass in einem aus den k Datenworten der Länge n und dem zusätzlichen Paritäts-Datenwort der Länge m gebildeten Datenblock eine vorbestimmte Parität hergestellt wird, wobei zur Berechnung der Parität jeweils bei im Datenstrom benachbarten Datenworten verschiedene Bitpositionen und damit unterschiedliche Wertigkeiten ausgewählt werden.

9. Anordnung nach einem der Ansprüche 7 oder 8, **gekennzeichnet durch** ein das Sendemodul aufweisendes Regel-/ oder Steuergerät und ein das Empfangsmodul aufweisendes Ein-/Ausgabemodul.

10. Anordnung nach einem der Ansprüche 7 oder 8, **gekennzeichnet durch** ein das Sendemodul aufweisendes Ein-/ Ausgabemodul und ein das Empfangsmodul aufweisendes Regel-/oder Steuergerät.

11. Anordnung nach einem der Ansprüche 7 oder 8, **gekennzeichnet durch** ein das Sendemodul aufweisendes Schnittstellenmodul.

12. Anordnung nach einem der Ansprüche 7 oder 8, **gekennzeichnet durch** ein das Empfangsmodul aufweisendes Schnittstellenmodul.

FIG 1

# FIG 2

# FIG 2A

## FIG 3

FIG 4

## FIG 5

## FIG 6

| A | 0 | 1 | 0 | 0 | 1 | 0 | 1 | 0 | Z(0) |

| B | 1 | 0 | 0 | 0 | 0 | 1 | 0 | 0 | swap (Z(1)) | 0 | 1 | 0 | 0 | 1 | 0 | 0 | 0 | Z(1) |

| A | 1 | 1 | 0 | 0 | 1 | 1 | 1 | 0 | A:=A XOR B |

FIG 7

**Europäisches Patentamt**

## EUROPÄISCHER RECHERCHENBERICHT

Nummer der Anmeldung

EP 06 11 8346

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 3 831 144 A (EN J) 20. August 1974 (1974-08-20) | 1-3 | INV. G05B19/418 |
| Y | * Abbildungen 1-3 * * Spalten 1-3; Anspruch 7 * ----- | 4,6-12 | H03M13/11 G06F11/10 |
| Y | PINAKI MAZUMDER: "AN ON-CHIP ECC CIRCUIT FOR CORRECTING SOFT ERRORS IN DRAM'S WITH TRENCH CAPACITORS" IEEE JOURNAL OF SOLID-STATE CIRCUITS, IEEE SERVICE CENTER, PISCATAWAY, NJ, US, Bd. 27, Nr. 11, 1. November 1992 (1992-11-01), Seiten 1623-1633, XP000320792 ISSN: 0018-9200 * Seite 1625 - Seite 1626 * ----- | 4 | |
| Y | US 4 435 807 A (SCOTT EDWARD W [US] ET AL) 6. März 1984 (1984-03-06) * Zusammenfassung * * Abbildung 14 * * Spalte 8, Zeilen 35-49 * ----- | 6 | |
| Y | US 2005/116835 A1 (GREHANT BERNARD [FR]) 2. Juni 2005 (2005-06-02) * Zusammenfassung * * Abbildung 14 * * Spalte 8, Zeilen 35-49 * * Abbildung 1 * * Absätze [0001], [0040] - [0049] * ----- | 7-12 | **RECHERCHIERTE SACHGEBIETE (IPC)** G05B H03M G06F |
| D,Y | EP 1 211 582 A1 (SIEMENS BUILDING TECH AG [CH]) 5. Juni 2002 (2002-06-05) * Abbildung 1 * * Absatz [0002] * ----- | 7-12 | |
| A | US 4 796 260 A (SCHILLING DONALD L [US] ET AL) 3. Januar 1989 (1989-01-03) * das ganze Dokument * ----- | 1-12 | |
| | -/-- | | |

Der vorliegende Recherchenbericht wurde für alle Patentansprüche erstellt

| Recherchenort | Abschlußdatum der Recherche | Prüfer |
|---|---|---|
| München | 13. November 2006 | Schriefl, Josef |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument
.........................................................
& : Mitglied der gleichen Patentfamilie, übereinstimmendes
   Dokument

EPO FORM 1503 03.82 (P04C03)

**Europäisches Patentamt**

## EUROPÄISCHER RECHERCHENBERICHT

**Nummer der Anmeldung**

EP 06 11 8346

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 2005/166130 A1 (COENE WILLEM M J [NL] ET AL) 28. Juli 2005 (2005-07-28) <br> * das ganze Dokument * <br> ----- | 1-12 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| München | 13. November 2006 | Schriefl, Josef |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................

& : Mitglied der gleichen Patentfamilie, übereinstimmendes Dokument

EPO FORM 1503 03.82 (P04C03)

**EP 1 887 446 A1**

ANHANG ZUM EUROPÄISCHEN RECHERCHENBERICHT
ÜBER DIE EUROPÄISCHE PATENTANMELDUNG NR.

EP 06 11 8346

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-11-2006

| Im Recherchenbericht angeführtes Patentdokument | Datum der Veröffentlichung | Mitglied(er) der Patentfamilie | Datum der Veröffentlichung |
|---|---|---|---|
| US 3831144 A | 20-08-1974 | KEINE | |
| US 4435807 A | 06-03-1984 | KEINE | |
| US 2005116835 A1 | 02-06-2005 | AU 2003212575 A1 | 13-10-2003 |
| | | CN 1643523 A | 20-07-2005 |
| | | EP 1488347 A2 | 22-12-2004 |
| | | ES 2229967 T1 | 01-05-2005 |
| | | FR 2837966 A1 | 03-10-2003 |
| | | WO 03083803 A2 | 09-10-2003 |
| | | JP 2005522077 T | 21-07-2005 |
| EP 1211582 A1 | 05-06-2002 | AT 241162 T | 15-06-2003 |
| | | DE 50002284 D1 | 26-06-2003 |
| US 4796260 A | 03-01-1989 | KEINE | |
| US 2005166130 A1 | 28-07-2005 | AU 2003226594 A1 | 27-10-2003 |
| | | CN 1647390 A | 27-07-2005 |
| | | WO 03088501 A2 | 23-10-2003 |
| | | JP 2005523601 T | 04-08-2005 |

Für nähere Einzelheiten zu diesem Anhang : siehe Amtsblatt des Europäischen Patentamts, Nr.12/82

EPO FORM P0461

**EP 1 887 446 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1211582 A1
- EP 1345122 A1